Europäisches Patentamt

European Patent Office

Office européen des brevets

(19)

(11) **EP 0 715 407 B1**

(12) **EUROPEAN PATENT SPECIFICATION**

(45) Date of publication and mention
of the grant of the patent:
**05.06.2002 Bulletin 2002/23**

(51) Int Cl.$^7$: **H03H 21/00**

(21) Application number: **96101757.1**

(22) Date of filing: **20.02.1992**

(54) **Method and apparatus for controlling coefficients of adaptive filter**

Verfahren und Vorrichtung zur Kontrolle der Koeffizienten eines adaptiven Filters

Procédé er appareil de commande des coéfficients d'un filtre adaptif

(84) Designated Contracting States:
**DE FR GB NL**

(30) Priority: **20.02.1991 JP 4900291**
**09.07.1991 JP 19588291**

(43) Date of publication of application:
**05.06.1996 Bulletin 1996/23**

(62) Document number(s) of the earlier application(s) in
accordance with Art. 76 EPC:
**92102833.8 / 0 500 096**

(73) Proprietor: **NEC CORPORATION**
**Tokyo (JP)**

(72) Inventor: **Sugiyama, Akihiko**
**7-1 Shiba, 5-chome, Minato-ku, Tokyo (JP)**

(74) Representative: **VOSSIUS & PARTNER**
**Siebertstrasse 4**
**81675 München (DE)**

(56) References cited:
**EP-A- 0 023 056**          **EP-A- 0 098 748**
**EP-A- 0 176 312**

• **SPEECH PROCESSING 2, DIGITAL SIGNAL
PROCESSING, GLASGOW, MAY 23 - 26, 1989,
vol. 2, 23 May 1989, INSTITUTE OF ELECTRICAL
AND ELECTRONICS ENGINEERS, pages
892-895, XP000090254 AKIHIKO SUGIYAMA ET
AL: "A FAST CONVERGENCE ALGORITHM FOR
ADAPTIVE FIR FILTERS"**

**Description**

The present invention relates to a method and apparatus for controlling coefficients of an adaptive filter for identifying an unknown system or predicting periodic signals using such adaptive filter, wherein interference signals are superimposed with the output signal from the unknown system. Its practical applications include noise cancellers to eliminate noise mixed with a signal from a main input terminal, echo cancellers to eliminate undesired reflection signals acoustically coupled to a microphone from a speaker or mismatching of 2-line to 4-line conversion circuit, line equalizers to equalize distortion caused by transmission lines and adaptive line enhancers to pick up periodic signals buried in a wideband signal or to suppress periodic interference signals to a wideband signal.

In identifying unknown systems or predicting periodic signals using an adaptive filter, noise cancellers and adaptive line enhancers (referred to as ALE hereunder) are known as typical examples where strong interference signals are superimposed with an output signal from an unknown system. See p.p. 1692-1716 of the PROCEEDINGS OF IEEE, 1975; Vol. 63, No. 12 (referred to as the Reference 1 hereunder). Also known are echo cancellers as disclosed in the IEEE JOURNAL ON SELECTED AREAS IN COMMUNICATIONS, 1984, Vol. 2, No. 2 at p.p. 283-297 (referred to as the Reference 2 hereunder). In echo cancellers, if double talk is not detected properly, the near-end signal acts as a strong interference signal. No double talk detection is made in echo cancellers to be used in 2-line bidirectional transmission. In this case, additional noise superimposed in the transmission lines will be a weak interference signal to the adaptive operation of the filter.

Noise cancellers suppress noise in the signal by applying a noise replica corresponding to the noise components in the main input terminal. Used for this end is an adaptive filter having a transfer function similar to the impulse response of the noise path from the noise source to the main input terminal. At this time, a coefficient for each tap of the adaptive filter is successively modified by correlating the reference noise derived at the reference input terminal with a difference signal obtained by subtracting the noise replica from the mixed signal of the noise and the signal.

On the other hand, echo cancellers suppress the echo by subtracting a pseudo echo or an echo replica from the echo signal caused by mismatching of the 2-line to 4-line conversion circuit in a 2-line bidirectional transmission line or a long distance telephone line or acoustical coupling between a microphone and a speaker. The echo replica is generated by using an active filter having a transfer function similar to the impulse response of the echo path. A coefficient of each tap of the adaptive filter is successively modified by correlating the reference signal on the reference input terminal with a difference signal obtained by subtracting the echo replica from the mixed signal of the echo signal and the additional noise.

Used in ALEs is an adaptive filter having a transfer function to pass only signal components whose periods are equal to those of the periodic signals for enhancing the periodic signals buried in a wideband signal. A coefficient of each tap of the adaptive filter for this application is a prediction coefficient to predict the periodic signals. It is successively modified by correlating the difference signal obtained by subtracting the predicted periodic signals or the output from the adaptive filter from the mixed signal of the periodic signals and the wideband signal on the main input terminal with the delayed mixed signal on the reference input. For enhancing the periodic signals, the output from the adaptive filter is used as the ALE output and the ALE is also used to suppress periodic interference signal to the wideband signal. In the latter case, the output signal is the difference or error signal instead of the output from the adaptive filter.

There are two typical coefficient modifications or converging algorithms. One is an LMS algorithm (see the Reference 1). The other is a Learning Identification Method (LIM) as set forth in p.p. 282-287 of The IEEE Transactions on Automatic Control, Vol. 12, No. 3 in 1967 (referred to as Reference 3 hereunder).

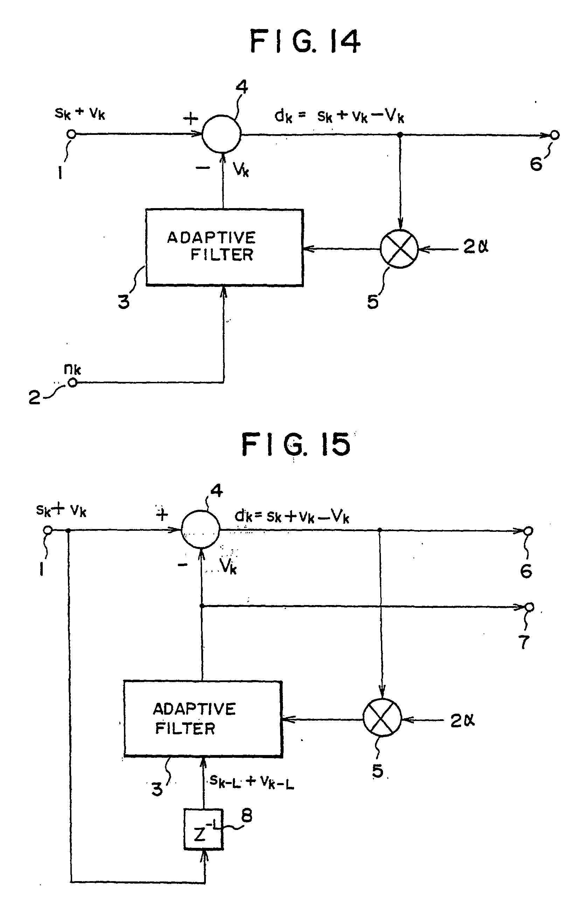

Illustrated in FIG. 14 is a block diagram of a conventional noise canceller. A mixed signal of a signal and noise detected on a main input terminal 1 is supplied to a subtracter 4. On the other hand, supplied to an adaptive filter 3 is a reference noise detected on a reference input terminal 2. The noise components are cancelled by the subtracter 4 which subtracts the noise replica generated by the adaptive filter 3 from the mixed signal. The subtracted output is supplied to an output terminal 6. Simultaneously, the output of the subtracter 4 is supplied to a multiplier 5 to be multiplied by the coefficient $2\alpha$ to be used for correcting the coefficient of the adaptive filter 3. Here, $\alpha$ is a constant and $2\alpha$ is known as a step size.

Let the signal, the reference noise, the noise to be cancelled and an additional noise to the signal be $S_k$ (k being an index to represent time), $n_k$, $V_k$ and $\delta_k$, respectively. The signal $u_k$ to be actually supplied to the subtracter 4 from the input terminal 1 is given by the following expression:

$$u_k = S_k + V_k + \delta_k \qquad (1)$$

A purpose of the noise cancellers is to generate the noise replica $V_k$ of the noise components $v_k$ in the above

expression (1) for cancelling the noise. The noise replica $V_k$ is adaptively generated by using a closed loop comprising the adaptive filter 3, the subtracter 4 and the multiplier 5 in FIG. 14. The closed loop provides the difference or error signal $d_k$ given by the following expression as the output signal from the subtracter 4. However, it is to be noted that $\delta_k$ is sufficiently small as compared to $S_k$ and is neglected in the expression:

$$d_k = S_k + v_k - V_k \tag{2}$$

In the above expression (2), $(v_k - V_k)$ is known as a residual noise. In the LMS algorithm, the m-th coefficient $C_{m,k}$ of the adaptive filter 3 is corrected in accordance with the following expression:

$$C_{m,k} = C_{m,k-1} + 2\alpha \cdot d_k \cdot n_{m,k-1} \tag{3}$$

A matrix format of the expression (3) for all of the N coefficients is as follows:

$$C_k = C_{k-1} + 2\alpha \cdot d_k \cdot n_{k-1} \tag{4}$$

Where, $C_k$ and $n_k$ are given by the following expressions, respectively:

$$C_k = [C_0 C_1 \ldots C_{N-1}]^T \tag{5}$$

$$n_k = [n_k n_{k-1} \ldots n_{K-N+1}]^T \tag{6}$$

Here, $[\cdot]^T$ represents a transposition of the matrix. On the other hand, in the LIM algorithm, correction of coefficients will be carried out in accordance with the following expression (7) rather than the expression (4).

$$C_k = C_{k-1} + (2\mu/N\sigma_n^2) \cdot d_k \cdot n_{k-1} \tag{7}$$

$\mu$ in the above expression (7) is the step size for LIM and $\sigma_n^2$ represents an average power of the input to the adaptive filter 3. $\sigma_n^2$ is used to make the step size $\mu$ counter proportional to the average power for stable convergence. There are a few methods to calculate $\sigma_n^2$. One example is to calculate in accordance with the following expression (8):

$$\sigma_n^2 = \sum_{j=0}^{N-1} n_{k-j}^2 \qquad \ldots (8)$$

The step sizes in the above expressions (4) and (7) define the converging speed of the adaptive filter and the residual noise level after convergence. In case of the LMS algorithm, if the value of $\alpha$ is larger, the convergence speed is faster but the final residual noise level increases. On the contrary, it is required to choose relatively small $\alpha$ in order to achieve a sufficiently low final residual noise level. However, this causes a relatively slow convergence speed. This is true about the step size $\mu$ in the LIM algorithm.

A VS algorithm has been proposed in order to meet the conflicting requirements in the step size to the converging speed and the final residual noise. See p.p. 309-316 of the IEEE Transactions on Acoustics, Speech and Signal Processing, 1986, Vol. 34, No. 2 (referred to as Reference 4 hereunder, in this context, reference is also made to EP-A-0 098 748. The VS algorithm uses step size matrix 2A instead of the step size $2\alpha$ in the LMS algorithm as represented by the above expression (4). Each component of A is controlled in response to the progress in convergence of the adaptive filter. The use of individual step size given by the step size matrix A rather than a common step size for each coefficient allows optimum step size for each coefficient depending on variations in magnitude of the self-correlation matrix component, thereby improving the converging speed. Actual correction of the coefficients will be performed by the following expression:

$$C_k = C_{k-1} + 2A \cdot d_k \cdot n_{k-1} \qquad (9)$$

$$A = [a_{i,j}]$$

$$a_{i,j} = 0 \qquad \text{for } i \neq j$$

$$\neq 0 \qquad \text{for } i = j$$

$a_{m,m}$ is determined by the successive pattern of the polarity $\text{sgn}[G_{m,k}]$ of the gradient component $G_{m,k}$ corresponding to the m-th tap, where $G_{m,k}$ is given by the following expression:

$$G_{m,k} = 2 \cdot \alpha_{m,m} \cdot d_k \cdot n_{m,k-1} \qquad (10)$$

In an ideal case where $d_k = v_k - V_k$, the polarity of $G_{m,k}$ directly represents the progress of convergence. However, $d_k$ is generally affected by $S_k$ as understood from the expression $d_k = S_k + v_k - V_k$. In order to reduce the influence of $S_k$, $a_{m,m}$ is halved if $\text{sgn}[G_{m,k}]$ changes $m_o$ times consecutively. On the other hand, it is doubled if sgn $[G_{m,k}]$ are equal for $m_1$ times consecutively. That is, the VS algorithm features to make equivalently $S_k + v_k - V_k \propto v_k - V_k$ by detecting succession of identical polarities or successive alternations of the polarity. However, there is a certain limitation in the variable range of $a_{m,m}$. That is, the maximum value $\alpha_{max} = 1/\lambda$ and the minimum value $\alpha_{min}$ is defined by a desired final residual noise. Here, $\lambda$ is the maximum inherent value of the autocorrelation matrix. The performance of the VS algorithm depends largely on the relationship between $S_k$ and $v_k - V_k$. The polarity changing pattern of the above $G_{m,k}$ is a function of the signal-to-noise ratio (SNR) and the spectrum of $S_k$. When the SNR is large, $|S_k| > |v_k - V_k|$ is almost always true and seriously affects polarity detection. Considering the fact that SNR is defined by the ratio of the signal and the noise in mathematical expectation of their instantaneous powers, $|S_k| > |v_k - V_k|$ is satisfied with a greater probability as $S_k$ contains more higher-frequency components even if SNR is low. In other words, when $S_k$ has many peaks and dips, it is most likely that $|S_k|$ is larger than $|v_k - V_k|$ in some of the peaks even if SNR is sufficiently low.

Illustrated in FIG. 15 is a block diagram of a conventional ALE corresponding to the noise canceller in FIG. 14. A mixed signal to be supplied to an input terminal 1 comprises a wideband signal $S_k$, a periodic signal $v_k$ and an additive noise $\delta_k$. On the other hand, supplied to an adaptive filter 3 is a delayed signal of the mixed signal on the input terminal 1 delayed by L by a delay element 8 and is given by:

$$u_{k-L} = S_{K-L} + V_{K-L} \qquad (11)$$

However, $\delta_k$ is neglected in the above expression (11) because it is sufficiently small compared with $S_k$. The difference signal $d_k$ given by the expression (2) is obtained by subtracting the prediction signal $V_k$ of $v_k$. generated by the adaptive filter 3 from the mixed signal $u_k$ of the expression (1). Derived from an output terminal 6 is a wideband signal with suppressed periodic interference signals. Also derived from an output terminal 7 is the enhanced periodic signals obtained by suppressing wideband noise. Coefficient correction of the adaptive filter 3 should be carried out by using $(v_k - V_k)$ which is a prediction error of the periodic signals. However, the actually derived difference signal $d_k$ contains the wideband signal $S_k$. As a result, the above discussions on $|S_k|$ and $|v_k - V_k|$ in the noise canceller are also applicable to the ALE. That is, a correct step size control in the VS algorithm depends on the relationship between $|S_k|$ and $|v_k - V_k|$ and no correct step size is obtained if $|S_k|$ is larger than $|v_k - V_k|$.

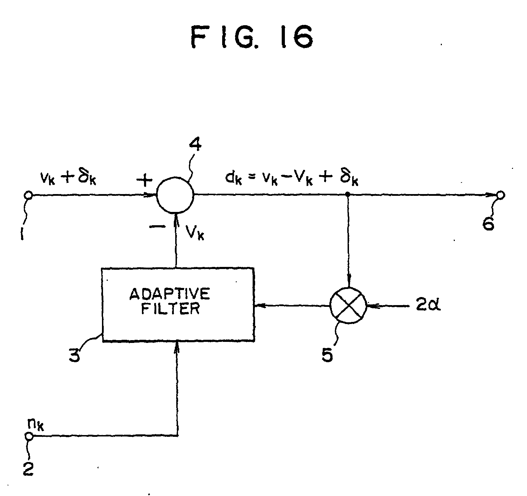

Illustrated in FIG. 16 is a block diagram of a conventional echo canceller corresponding to the noise canceller in FIG. 14. The block diagrams in FIGS. 16 and 14 are identical to each other but differ only in input signals. Supplied to an input terminal 1 is a signal comprising an echo $v_k$ and an additive noise $\delta_k$.

$$u_k = v_k + \delta_k \qquad (12)$$

On the other hand, supplied to an adaptive filter 3 is $n_k$ through an input terminal 2. $n_k$ represents an input signal to a 2-line to 4-line conversion transformer in case of a bidirectional transmission circuit or a signal to be supplied to a speaker in case of an echo due to acoustic coupling. An echo replica $V_k$ of $v_k$ generated by the adaptive filter 3 is subtracted from $u_k$ in the expression (12) derived from the input terminal 1 to obtain the difference signal $d_k$ in the following expression (13):

$$d_k = v_k - V_k + \delta_k \qquad\qquad (13)$$

Derived from an output terminal 6 is the echo cancelled signal. Coefficient correction of the adaptive filter 3 should be performed using the residual echo ($v_k - V_k$). In practice, however, the additional noise $\delta_k$ is contained in the difference signal $d_k$. Although $\delta_k$ is fairly small in general, it interferes the residual echo when the residual echo becomes sufficiently small.

In order to minimize the effect of interference signals, it is required to increase both $m_o$ and $m_1$ and minimize $\alpha_{min}$. However, this will adversely make the advantage of the VS algorithm less attractive. Additionally, as understood from the expression (9), the VS algorithm requires to store in a memory a large number of step sizes equal to the number of coefficients, thereby requiring a large memory capacity as the number of taps increases and in turn making the hardware very expensive.

It is therefore an object of the present invention to provide a method and an apparatus for controlling coefficients of an adaptive filter with shorter converging time and smaller scale of hardware.

This object is achieved with a method and an apparatus as specified in claims 1 and 6, respectively.

According to the present invention there is provided a method or apparatus for controlling coefficients of an adaptive filter for identifying an unknown system or predicting periodic signals by correcting coefficients of the adaptive filter in such a manner that the difference signal obtained by subtracting an output signal of the adaptive filter from a mixed signal of the output signal from the unknown system and an interference signal comprising the steps or means for obtaining the information relating to the magnitude of the output of the adaptive filter, and adaptively varying the amount of correction in coefficients of the adaptive filter in response to the obtained information.

The coefficient control method and apparatus for an adaptive filter according to the present invention reduces converging time by controlling the magnitude of the step size by using the fact that the absolute values of coefficients of the adaptive filter increase and saturate as the coefficients converge. Since the absolute values of coefficients depend on the transfer function of the path to be identified, such dependency can be avoided by using the ratio of the long-time and short-time averages in the average value of the coefficients. Since the absolute value of the coefficients as well as the average value of the absolute output signal from the adaptive filter saturate to a constant value, the converging time can be reduced by controlling the step size using the information relating to the magnitude of the filter output signal instead of the information relating to the magnitude of the filter coefficients.

FIG. 1 is a block diagram of an embodiment of related art to the present invention;

FIG. 2 is a detailed scheme of the adaptive filter 3 in FIG. 1;

FIG. 3 is a first example of an information extraction circuit 9;

FIG. 4 is a second example of an information extraction circuit 9;

FIG. 5 is one example of an arithmetic circuit 10 to obtain $y_k$;

FIG. 6 is an example of the averaging circuit;

FIG. 7 is an example of the divider circuit 54;

FIG. 8 is an example of the inverse circuit 32;

FIG. 9 is a block diagram of adaptively controlling the step size using the filter output;

FIG. 10 is a block diagram of ALE according to related art to the present invention corresponding to the noise canceller in FIG. 1;

FIG. 11 is a block diagram of ALE according to the present invention corresponding to the noise canceller in FIG.2;

FIGS. 12 and 13 are block diagrams of applying the present invention to an echo canceller;

FIG. 14 is a block diagram of a conventional noise canceller;

FIG. 15 is a block diagram of a conventional ALE corresponding to the noise canceller in FIG. 14; and

FIG. 16 is a block diagram of a conventional echo canceller corresponding to the noise canceller in FIG. 14.

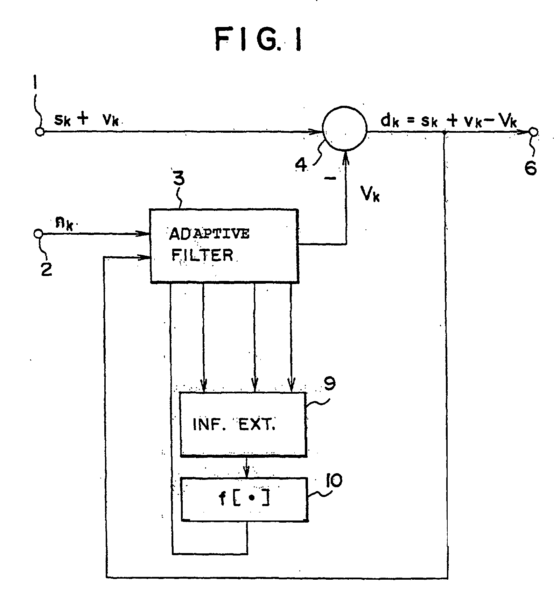

The present invention will be described in detail hereunder by reference to the accompanying drawings. Illustrated in FIG. 1 is a block diagram of an embodiment of related art to the present invention. In FIG. 1, the same reference numerals as those in FIG. 14 are used to refer like functional blocks. A primary difference between FIGS. 1 and 14 is in the magnitude of the step size. That is the step size $2\alpha$ to be supplied to the multiplier 5 in FIG. 14 is fixed but varies in FIG. 1 in response to the magnitude of coefficients for the adaptive filter. For this end, there is employed an information extraction circuit 9 to extract the information relating to the magnitude of coefficients. Also employed in FIG. 1 is an arithmetic circuit 10 for controlling the step size using the extracted information.

By reference to FIG. 1, supplied to the information extraction circuit 9 are the adaptive filter coefficients from the adaptive filter 3. The information extraction circuit 9 extracts the information relating to the magnitude of coefficients for supplying to the arithmetic circuit 10. The arithmetic circuit 10 performs arithmetic operation as defined by b = f[a] based on the signal a to be supplied from the information extraction circuit 9 and the output is supplied to the adaptive filter 3.

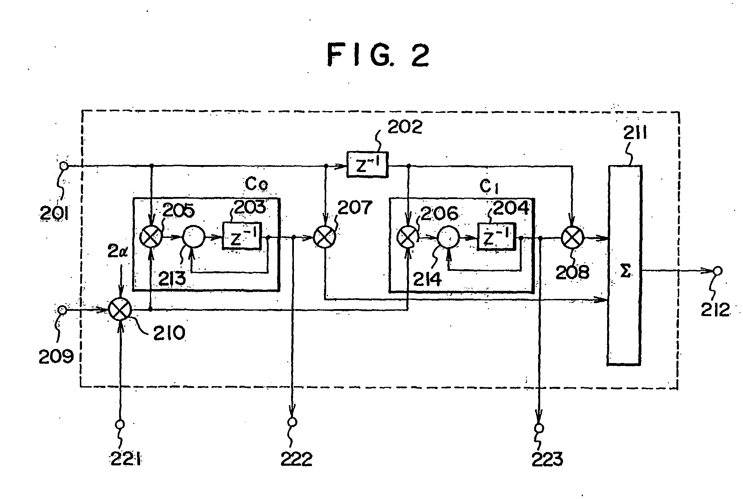

Illustrated in FIG. 2 is a detailed block diagram of the adaptive filter 3 in FIG. 1. For convenience, it is assumed that the adaptive filter 3 has only 2 taps. An input signal from the input terminal 2 in FIG. 1 is supplied to an input terminal 201 in FIG. 2. Also, supplied to an input terminal 209 is the output from the subtracter 4 in FIG. 1, or the error signal. The output signal on an output terminal 212 is supplied to the subtracter 4 as the output of the adaptive filter 3 in FIG. 1. Both signals from output terminals 222 and 223 are supplied to the information extraction circuit 9. The output signal of the arithmetic circuit is supplied to an input terminal 221.

The input signal to be supplied to the input terminal 201 is supplied to a delay element 202 and multipliers 205 and 207. The input signal on the input terminal 201 is also supplied to multipliers 206 and 208 after a delay equivalent to one sampling period. In other words, the signals to be supplied to the multipliers 205-206 and 207-208 have a time difference equal to one sampling period. Now, the input signal sample to be supplied to the input terminal 201 at time $kT$ (T representing the sampling period) is represented as $n_k$. $n_k$ and $n_{k-1}$ are supplied to the multipliers 205-207 and 206-208, respectively. On the other hand, let $d_k$ and $y_k$ be the error signal to a multiplier 210 from the input terminal 209 and the signal to the multiplier 210 from the arithmetic circuit 10 by way of the input terminal 221, respectively. Then, the output from the multiplier 210 is equal to $2\alpha \cdot y_k \cdot d_k$. The output of the multiplier 210 is multiplied by the input signals $n_k$ and $n_{k-1}$ in the multipliers 205 and 206 before being transferred to adders 213 and 214, respectively. That is, the signals to be supplied to the adders 213 and 214 are $2\alpha \cdot y_k \cdot d_k \cdot n_k$ and $2\alpha \cdot y_k \cdot d_k \cdot n_{k-1}$, respectively. Fedback respectively to the adders 213 and 214 are the outputs from delay elements 203 and 204, respectively. The outputs from the delay elements 203 and 204 are coefficients for the adaptive filter 3 and are represented by $C_{0,k}$ and $C_{1,k}$ at respective time $kT$. Then, the added outputs transmitted to the delay elements 203 and 204 from the adders 213 and 214 will be $C_{0,k}+2\alpha \cdot y_k \cdot d_k \cdot n_k$ and $C_{1,k}+2\alpha \cdot y_k \cdot d_k \cdot n_{k-1}$, respectively. These signals are delayed by one sampling period due to the delay elements 203 and 204. Therefore,

$$C_{0,k+1} = C_{0,k} + 2\alpha \cdot y_k \cdot d_k \cdot n_k \qquad (14)$$

$$C_{1,k+1} = C_{1,k} + 2\alpha \cdot y_k \cdot d_k \cdot n_{k-1} \qquad (15)$$

$C_{0,k}$ and $C_{1,k}$ are supplied respectively to the output terminals 214 and 215 for step size control.

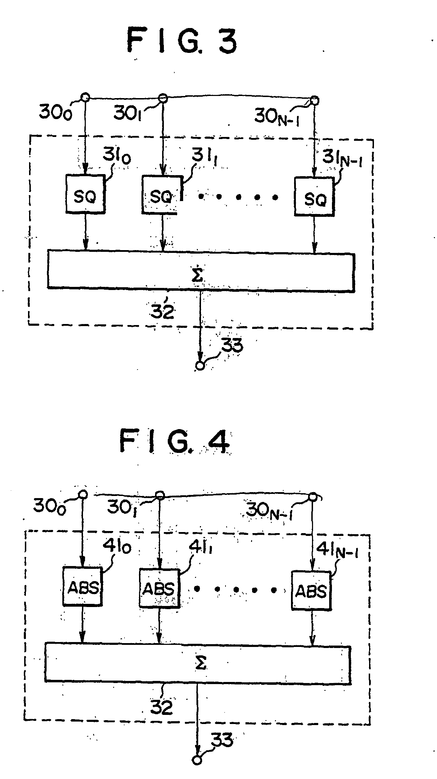

Illustrated in FIG. 3 is a block diagram of a first example of the information extraction circuit 9, wherein a squared value of the coefficient is used as the information relating to the magnitude of the coefficients of the adaptive filter. Supplied to input terminals $30_0$, $30_1$, ..., $30_{N-1}$ are N coefficients from the adaptive filter 3. It is to be noted here that N is the number of taps of the adaptive filter 3. N = 2 is the particular example of the adaptive filter 3 in FIG. 2. The signals supplied to the input terminals $30_0$, $30_1$, ..., $30_{N-1}$ are squared by respective squaring circuits $31_0$, $31_1$, ..., $31_{N-1}$ to be supplied to a multi-input adder 32. The multi-input adder 32 provides the sum of the squared values to be derived from its output terminal 33. Referring to the description for FIG. 2, the signal $a_k$ derived from the output terminal 33 is given by the following expression:

$$a_k = \sum_{j=0}^{N-1} C_{j,k}^2 \qquad \dots (16)$$

Illustrated in FIG. 4 is a block diagram of a second example of the information extraction circuit 9, wherein absolute values of the coefficients are used as the information relating to the magnitude of the coefficients of the adaptive filter. It is to be noted that the absolute value of each coefficient saturates as adaption of the adaptive filter coefficients progresses, thereby saturating the sum of the absolute values. Accordingly, the absolute values can be used as a measure to see the degree of convergence. That is, the step size can be controlled by the sum of the absolute values of the filter coefficients instead of the squared values thereof. Supplied to the input terminals $30_0$, $30_1$, $30_2$, ..., $30_{N-1}$ are N coefficients from the adaptive filter 3, which are then converted into the corresponding absolute values by absolute value circuits $41_0$, $41_1$, ..., $41_{N-1}$ before being supplied to the multi-input adder 32. The multi-input adder 32 operates to provide from its output terminal 33 the sum of the absolute values $a_k$ which is given by the following expression:

$$a_k = \sum_{j=0}^{N-1} |c_{j,k}| \qquad \cdots (17)$$

For simplicity, a description is given hereunder for a case where $a_k$ is defined by the expression (16).

The obtained $a_k$ is supplied to the arithmetic circuit 10 which calculates and provides an output $b_k$ in accordance with the definition $b_k = f[a_k]$. The calculated output $b_k$ is fed to the adaptive filter 3 by way of the input terminal 213. Therefore,

$$y_k = f[\sum_{j=0}^{N-1} c_{j,k}^2] \qquad \cdots (18)$$

The equations (14), (15) are basically the same as the equation (3). Only the difference is the use of a variable step size $2\alpha \cdot y_k$ instead of the fixed step size $2\alpha$. A method of controlling $y_k$, i.e., how to calculate $f[\cdot]$ is an essential factor to achieve high-speed, stable convergence.

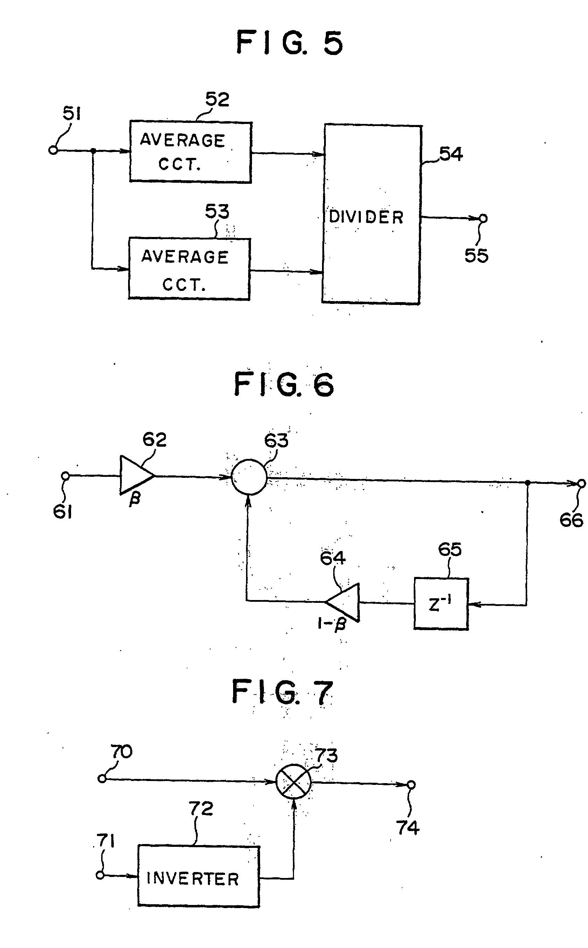

Illustrated in FIG. 5 is a block diagram of the arithmetic circuit 10 to obtain $y_k$. The input signal derived from the input terminal 51 is fed to both averaging circuits 52, 53. That is, the inputs to the averaging circuits 52, 53 are $a_k$ or the output from the information extraction circuit 9. The averaging circuit 52 calculates a short-time-constant moving average $[\cdot]$ of the input signal while the averaging circuit 53 calculates a long-time-constant moving average $\overline{\cdot}$ of the input signal. The outputs $u_k$ and $z_k$ from the averaging circuits 52 and 53 are given by the following expressions, respectively:

$$u_k = [\sum_{j=0}^{N-1} c_{j,k}^2] \qquad \cdots (19)$$

$$z_k = \overline{\sum_{j=0}^{N-1} c_{j,k}^2} \qquad \cdots (20)$$

The divider 54 calculates the ratio of $u_k$ and $z_k$ to provide on its output terminal 55 $y_k$ given by the following expression:

$$y_k = \frac{z_k}{u_k} = \frac{\overline{\sum_{j=0}^{N-1} c_{j,k}^2}}{[\sum_{j=0}^{N-1} c_{j,k}^2]} \qquad \cdots (21)$$

Now, $a_k$ increases and saturates as k increases. The short-time average $\underline{a}_k$ increases faster than the long-time average $[a_k]$. As a result, it is understood that the ratio $y_k = \underline{a}_k/[a_k]$ decreases gradually from a value larger than 1 to converge ultimately to 1. This means that the signal $y_k$ to be supplied to the output terminal 55 from the divider 54 is relatively large immediately after initiation of the coefficient correction but decreases gradually as the adaptive filter 3 continues its adaptation. Finally, it becomes equal to 1. The signal $y_k$ as obtained in the above manner is fed to the input terminal 213 in FIG. 2 as the output from the arithmetic circuit 10 in FIG. 1.

The use of this value $y_k$ multiplied by the fixed step-size in accordance with the equations (14) and (15) will make the effective step-size large initially and subsequently equal to the final value $2\alpha$ after convergence, thereby shortening the converging time.

Illustrated in FIG. 6 is a block diagram of the averaging circuit which is known as a first-order leaky integrator with a leaky factor $\beta$ ($0 < \beta < 1$). A signal supplied to its input terminal 61 is multiplied by the factor of $\beta$ in an integrator 62 before being fed to an adder 63. The output from the adder 63 is fed to an output terminal 66 and also to a delay element 65. A delayed signal delayed by one clock period in the delay element 65 is multiplied by the coefficient of $1 - \beta$ in a multiplier 64 before being fed to the adder 63. The adder 63 accumulates the signals fed to the input terminal 61 with 1 clock delay, thereby integrating the signals. At this time, "leak " will be caused in the multiplier 64. As understood from the values of the multipliers 62 and 64, when the signal fed to the input terminal 61 is relatively stationary, the output signal from the output terminal 66 increases gradually before saturating. By proper selection of the constant $\beta$, the saturation value can simulate the average value of the input signal. If $\beta$ is small, $1 - \beta$ is approximately 1 and the signal on the output terminal 66 is fed back to the adder 63 with no modification, thereby providing a moving averaging circuit of relatively long time constant. On the other hand, if $\beta$ is large, the feedback signal from the output terminal 66 to the adder 63 will be rapidly decreasing. This will increase the contribution of the current signal fed to the multiplier 62 from the input terminal 61, thereby shortening the time constant of the moving averaging circuit. Accordingly, it is understood that the averaging circuit as illustrated in FIG. 6 can be used for the averaging circuits 52 and 53 by proper selection of the leaky factor $\beta$. When the first-order leaky integrator in FIG. 6 is used for the averaging circuits 52 and 53, the leaky factors of the averaging circuits 52 and 53 are chosen respectively as $\beta_j$ and $\beta_1$ to obtain the following equations from the above equations (19) and (20):

$$u_k = \beta_1 \left( \sum_{j=0}^{N-1} C_{j,k}^2 \right) + (1-\beta_1)u_{k-1} \qquad \cdots (22)$$

$$z_k = \beta_s \left( \sum_{j=0}^{N-1} C_{j,k}^2 \right) + (1-\beta_s)z_{k-1} \qquad \cdots (23)$$

As a result, $y_k$ is expressed as follows:

$$y_k = \frac{\beta_s \left( \sum_{j=0}^{N-1} C_{j,k}^2 \right) + (1-\beta_s)z_{k-1}}{\beta_1 \left( \sum_{j=0}^{N-1} C_{j,k}^2 \right) + (1-\beta_1)u_{k-1}} \qquad \cdots (24)$$

Considering that $y_k$ is a decreasing function with $z_o = u_o = 0$, the maximum value of $y_k$ is $y_1 = \beta_j/\beta_1$ and is constant regardless of any external condition such as coefficients of the adaptive filter and the reference signals therefor. Although FIG. 6 illustrates an example of a recursive type averaging circuit, any other circuit configuration such as a transversal type may be used as well.

Illustrated in FIG. 7 is a block diagram of the divider 54 comprising an inverter and a multiplier. The signals fed to the divider 54 in FIG. 5 from the averaging circuits 52 and 53 are fed to input terminals 70 and 71, respectively. The inverter 72 provides an inverse of the signal fed to the input terminal 71 to be transferred to the multiplier 73 where the inverse signal and the signal from the input terminal 70 are multiplied before being transferred to an output terminal 74. The product on the output terminal is fed to the output terminal 55 in FIG. 5.

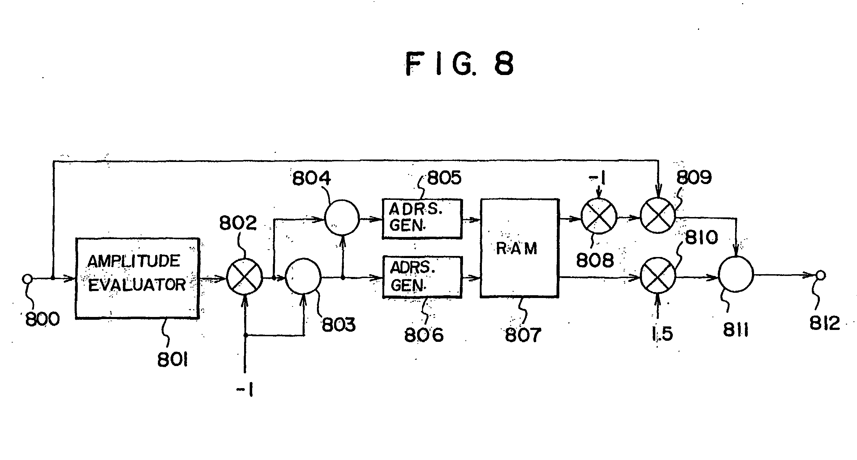

Illustrated in FIG. 8 is a block diagram of one example of the inverse circuit 32 to simulate the inverse calculation using exponent. Let a signal to be inverted be $p_k$ and the inverse $q_k = 1/p_k$. $q_k$ may be approximated by the following linear equation:

$$q_k = -2^{-2r-1}p_k + 2^{-r-1} \cdot (2^{-1}+1) \tag{25}$$

Here, r is the largest integer not exceeding $\log_2(p_k)$. The equation (25) is simple to realize because it comprises exponent of 2 and additions and subtractions. The inverter in FIG. 8 operates as follows:

Applied to an input terminal 800 in FIG. 8 is the signal to be fed to the inverter 72 from the input terminal 71 in FIG. 7. The signal is fed to an amplitude evaluation circuit 801 and a multiplier 809. The amplitude evaluation circuit 801 calculates the maximum integer r not exceeding $\log_2(p_k)$ for the input signal $p_k$. The maximum integer r is fed to a multiplier 802 which is multiplied by -1 before being transmitted to adders 803 and 804. In the adder 803, -1 is added to the signal from the multiplier 802 to obtain -r-1 to be fed to an address generation circuit 806. Added to the signal from the multiplier 802 in the adder 804 is -r-1, or the output from the multiplier 803 to feed the resulting signal -2r-1 to the address generation circuit 805. The address generation circuits 805 and 806 generate respective addresses to a RAM 807 for obtaining from the RAM exponents of 2 corresponding to the fed signals. The RAM 807 supplies to a multiplier 808 $2^{-2r-1}$ corresponding to the address generation circuit 805 while $2^{-r-1}$ is supplied to a multiplier 810 in response to the address generation circuit 806. The multiplier 810 multiplies the signal fed from the RAM 807 by 1.5 before being fed to a multiplier 811. The multiplier 808 multiplies the signal fed from the RAM 807 by -1 before being fed to the multiplier 809. The signal $-2^{-2r-1}$ fed to the multiplier 809 is multiplied by the input signal $p_k$ fed from the input terminal 800 to be fed to the adder 811. The adder 811, then, adds the signal $-2^{-2r-1}p_k$ from the multiplier 809 and the signal $1.5 \cdot 2^{-r-1}$ from the multiplier 810 to derive the resulting output $-2^{-2r-1} \cdot p_k + 1.5 \cdot 2^{-r-1}$ from an output terminal 812. The output signal from the output terminal 812 is the signal to be fed to the multiplier 73 in FIG. 7.

It is assumed so far that $a_k$ is defined by the equation (16), i.e., the sum of the squared values of filter coefficients is fed to the arithmetic circuit 10. However, it is to be understood that the descriptions also apply to $a_k$ defined by the equation (17), i.e., the sum of the absolute values of filter coefficients is fed to the arithmetic circuit 10. Also, similar descriptions hold true for adaptive filters having more than 2 taps.

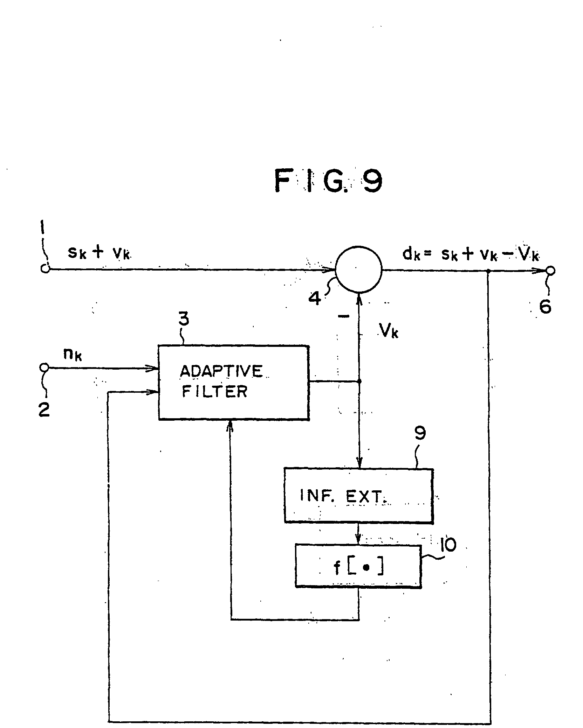

Although the above descriptions are made on the step-size control using the sum of the squared values of the filter coefficients, it is to be understood that the step-size control may be made using the information relating to the magnitude of the filter output signal instead of the filter coefficients because the average values of the adaptive filter output in either absolute or squared values will saturate as well as the absolute values in the coefficients to a stationary or a pseudo stationary input signal. Illustrated in FIG. 9 is a block diagram for adaptively controlling the step size using the filter output. A difference from the example as illustrated in FIG. 1 is in that the signal to be supplied to the information extraction circuit 9 is the output from the adaptive filter 3. As a result, there is only one input in the information extraction circuit 9. However, the same construction as illustrated in FIG. 3 or FIG. 4 may be used without any correction. When there are more than one input terminals in the information extraction circuit 9, either one of the terminals may be used to feed the output from the adaptive filter 3 thereto. Also, the adaptive filter 3 may be the same as illustrated in FIG. 2 with leaving the output terminals 214 and 215 unconnected.

When the first example in FIG. 3 is used as the information extraction circuit 9, the signal $a_k$ on the output terminal 33 will be expressed:

$$a_k = V_k^2 = \left( \sum_{j=0}^{N-1} C_{j,k} n_{k-j} \right)^2 = C_k^T n_k C_k^T n_k \cdots \tag{26}$$

On the contrary, when the second example in FIG. 4 is used as the information extraction circuit 9, the signal $a_k$ derived from the output terminal 33 will be expressed:

$$a_k = |V_k| = \left| \sum_{j=0}^{N-1} C_{j,k} n_{k-j} \right| = |C_k^T n_j| \cdots \tag{27}$$

For simplicity, in a case where $a_k$ is defined by the equation (26), the following equations will be obtained in corresponding to the equations (18) through (24):

$$y_k = f\left[\left(\sum_{j=0}^{N-1} c_{j,k} n_{k-j}\right)^2\right] \qquad \ldots (28)$$

$$u_k = \left[\left(\sum_{j=0}^{N-1} c_{j,k} n_{k-j}\right)^2\right] \qquad \ldots (29)$$

$$z_k = \overline{\left(\sum_{j=0}^{N-1} c_{j,k} n_{k-j}\right)^2} \qquad \ldots (30)$$

$$y_k = \frac{z_k}{u_k} = \frac{\overline{\left(\sum_{j=0}^{N-1} c_{j,k} n_{k-j}\right)^2}}{\left[\left(\sum_{j=0}^{N-1} c_{j,k} n_{k-j}\right)^2\right]} \qquad \ldots (31)$$

$$u_k = \beta_l \left(\sum_{j=0}^{N-1} c_{j,k} n_{k-j}\right)^2 + (1-\beta_l) u_{k-1} \qquad \ldots (32)$$

$$z_k = \beta_s \left(\sum_{j=0}^{N-1} c_{j,k} n_{k-j}\right)^2 + (1-\beta_s) z_{k-1} \qquad \ldots (33)$$

$$y_k = \frac{\beta_s \left(\sum_{j=0}^{N-1} c_{j,k} n_{k-j}\right)^2 + (1-\beta_s) z_{k-1}}{\beta_l \left(\sum_{j=0}^{N-1} c_{j,k} n_{k-j}\right)^2 + (1-\beta_l) u_{k-1}} \qquad \ldots (34)$$

Other circuit operations are identical to those as described above by reference to FIG. 1 and no detailed descriptions will be given herein.

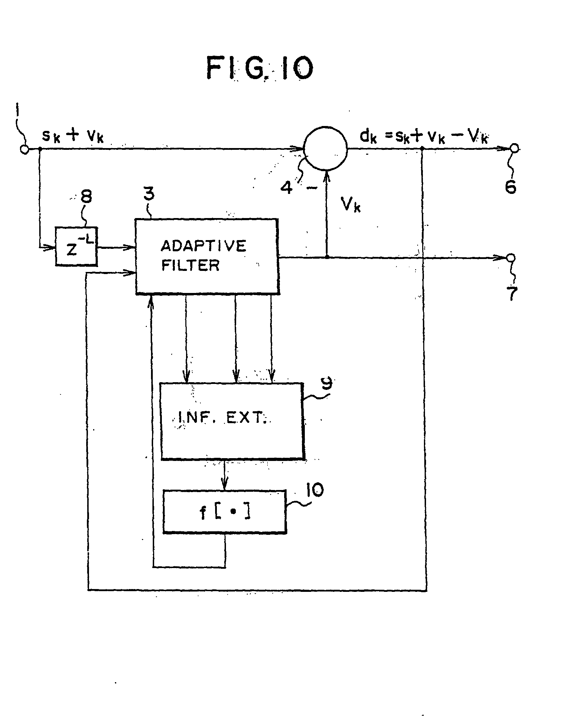

Illustrated in FIG. 10 is a block diagram of the ALE according to related art to the present invention corresponding to the noise canceller in FIG. 1. The mixed signal supplied to the input terminal 1 comprises a wideband signal $S_k$, a periodic signal $v_k$ and an additional noise $\delta_k$. Fed to the adaptive filter 3 is the mixed signal on the input terminal 1 delayed by the time L in the delay element 8, or the signal $u_{k-L}$ given by the equation (11). A predicted signal

$V_k$ of $v_k$ as generated by the adaptive filter 3 is subtracted from the mixed signal $u_k$ to obtain the difference signal $d_k$ as given by the equation (2). Derived from output terminals 6 and 7 are the wideband signal with suppressed periodic interference signal and the periodic signal enhanced by suppressing the wideband noise. Coefficient correction of the adaptive filter 3 will be carried out in the exactly same manner as the embodiment in FIG. 1 using the filter coefficients.

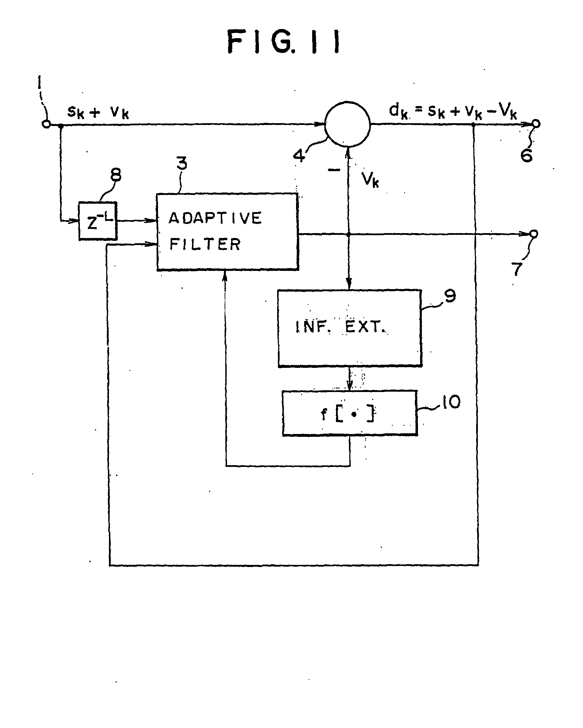

Illustrated in FIG. 11 is a block diagram of the ALE according to the present invention corresponding to the noise canceller in FIG. 9. The relationship between the embodiments in FIGS. 11 and 10 is equal to that between the embodiments in FIGS. 9 and 1, thereby requiring no detailed description of FIG. 11.

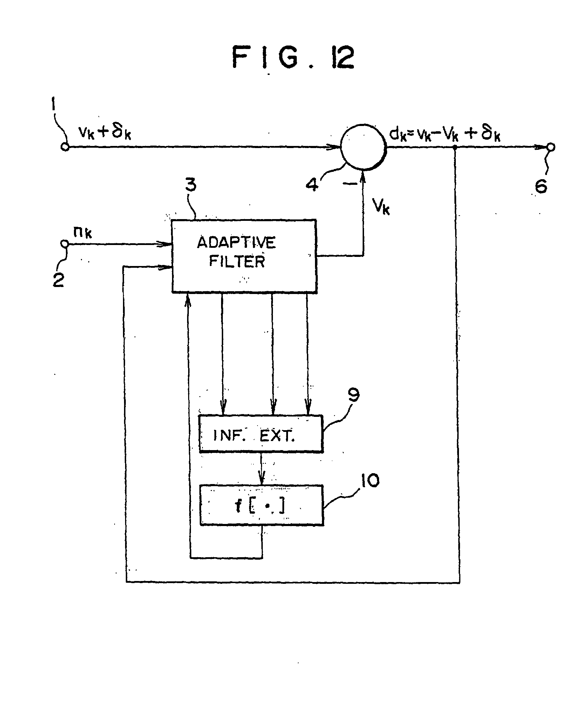

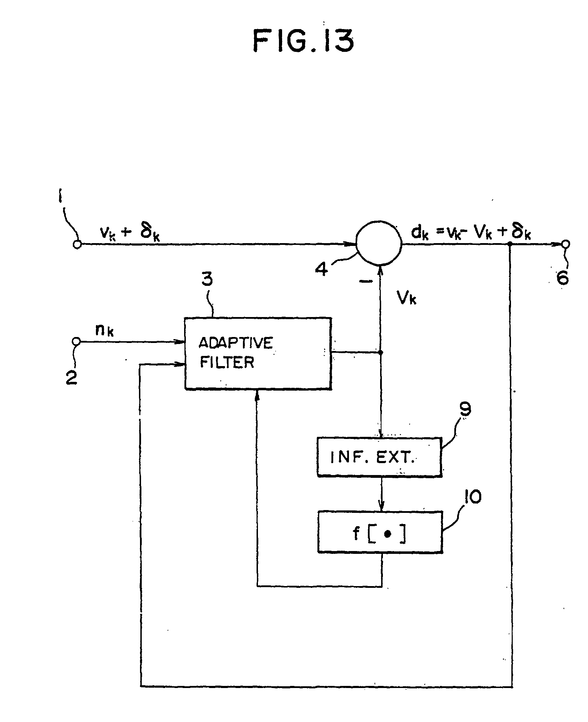

The present invention is also applicable to an echo canceller. Illustrated in FIGS. 12 and 13 are embodiments to apply the present invention to an echo canceller. FIGS. 12 and 13 are simply replacement of $S_k+v_k$ and $S_k+v_k-V_k$ by $v_k+\delta_k$ and $v_k-V_k+\delta_k$ in FIGS. 1 and 9. Accordingly, no detailed description will be given herein.

As described hereinbefore, a difference between LIM and LMS is the use of the step size $\mu$ divided by the average power $\sigma_n^2$ fed to the adaptive filter 3 instead of $\alpha$. The method of varying the step size in the above description in connection with the present invention will be applied to LIM without any correction.

**Claims**

1. A method of controlling coefficients of an adaptive filter (3) for identifying an unknown system or predicting periodic signals by receiving a mixed signal of the output signal from said unknown system including an interference signal or of the periodic signals and a wideband signal, and correcting coefficients of said adaptive filter (3) by means of a difference signal which is obtained by subtracting an output signal of the adaptive filter (3) from said mixed signal said adaptive filter (3) receiving a reference signal, said method comprising the steps of:

   extracting information directly corresponding to the magnitude of the output signal of said adaptive filter (3); and
   and additionaly adaptively varying the amount of correction of the coefficients of said adaptive filter on the basis of the extracted information,

   wherein the amount of correction in coefficients of said adaptive filter is adaptively varied in response to the ratio between the short-time average and the long-time average of the information on the magnitude of the output signal.

2. A method as defined in claim 1, wherein as said information relating to the output signal a square value of the output signal of said adaptive filter is used.

3. A method as defined in claim 1, wherein as said information relating to the output signal an absolute value of the output signal of said adaptive filter is used.

4. A method as defined in claim 1, wherein the ratio between the short-time and long-time averages is achieved by inverting and multiplying operations with the inverting operation being made by a linear approximation of exponent of 2.

5. A method as defined in claim 4, wherein the inverse of a variable X in the inverse operation is obtained by a linear aproximation of $-2^{-2-r}X + 2^{-r-1}\cdot(2^{-1}+1)$ using the maximum integer r not exceeding $\log_2(X)$.

6. A coefficient control apparatus for controlling coefficients of an adaptive filter (3) which generates a pseudo output to an unknown system to identify said unknown system, or predicts periodic signals on receiving a reference signal, comprising a first substracter (4) for subtracting the pseudo output from a mixed signal of the output signal of the unknown system and interference signals or of the periodic signals and a videband signal, for identifying the unknown system, or for generating predicted signals in response to said periodic signals, respectively
   an information extraction circuit (9) to extract information a directly corresponding to the magnitude of the output signal of said adaptive filter (3) by receiving the output signal from the adaptive filter (3); and
   an arithmetic circuit (10) receiving the output a of said information extraction circuit (9) for calculating and providing a signal b which decrease as the output a increases or increases as the output a decreases;
   said adaptive filter (3) correcting the coefficients of the adaptive filter (3) using the outputs from the first subtracter (4), and said arithmetic circuit (10), and the reference signal,
   wherein the amount of correction in coefficients of said adaptive filter is adaptively varied in response to the ratio between the short-time average and the long-time average of the information on the magnitude of the output signal.

7. An apparatus

**EP 0 715 407 B1**

as set forth in claim 6, wherein said information extraction circuit (9) comprises a square circuit (31) for developing the output of said adaptive filter.

8. An apparatus.
   as set forth in claim 6, wherein said information extraction circuit (9) comprises an absolute value circuit (41) for developing an absolute value of the output of said adaptive filter.

9. An apparatus
   as set forth in any of claims 6 to 8, wherein said arithmetic circuit (10) comprises a first averaging circuit (52) for averaging an input signal, a second averaging circuit (53) for averaging the same input signal with a different averaging time constant from the averaging time constant in said first averaging circuit, and a divider (54) for developing a ratio of said first averaging circuit and second averaging circuit.

10. An apparatus as set forth in
    claim 9, wherein said divider (54) comprises an inverter (72) for outputting an inverted signal of the output from said second averaging circuit (53) and a first multiplier (73) for multiplying the inverted signal with the output from said first averaging circuit (52).

11. An apparatus as set forth in
    claim 10, wherein said arithmetic circuit (10) is an inverse circuit comprising:

    an amplitude evaluation circuit (801) to provide the maximum integer r not exceeding $\log_2(X)$ of an input signal X;
    a second multiplier (802) to multiply the output of said amplitude evaluation circuit by -1;
    a second adder (803) to add -1 to the output of said second multiplier;
    a third adder (804) to provide the sum of the outputs of said second multiplier (802) and said second adder (803);
    a first address generation circuit (805) to provide a RAM address signal to give an exponent of 2 corresponding to the output of said third adder (804) ;
    a second address generation circuit (806) to provide a RAM address signal to give an exponent of 2 corresponding to the output of said second adder(803);
    a RAM (807)to provide a corresponding exponent output of 2 on receiving the outputs of said first and second address generation circuits;
    a third multiplier (808) to multiply the output corresponding to the address generated from said first address generation circuit in said RAM by -1;
    a fourth multiplier (809) to multiply the output of said third multiplier by the input signal to the input terminal;
    a fifth multiplier (810) to multiply the output corresponding to the address generated by said second address generation circuit in said RAM by 1.5; and
    a fourth adder (811) to add the outputs of said fifth and fourth multipliers for outputting from the output terminal.

**Patentansprüche**

1. Verfahren zur Kontrolle der Koeffizienten eines adaptiven Filters (3) zum Erkennen eines unbekannten Systems oder zum Voraussagen periodischer Signale durch Empfangen eines gemischten Signals des Ausgangssignals vom unbekannten System einschließlich eines Interferenzsignals oder der periodischen Signale und eines Breitbandsignals, und Korrigieren von Koeffizienten des adaptiven Filters (3) durch ein Differenzsignal, das erhalten wird durch Subtrahieren eines Ausgangssignals des adaptiven Filters (3) von dem gemischten Signal, wobei der adaptive Filter (3) ein Referenzsignal empfängt, wobei das Verfahren die folgenden Schritte aufweist:

   Extrahieren von Information, die direkt der Größenordnung des Ausgangssignals des adaptiven Filters (3) entspricht, und
   zusätzlich adaptives Variieren der Korrekturgröße der Koeffizienten des adaptiven Filters auf der Basis der extrahierten Information,

   wobei die Größe der Korrektur der Koeffizienten des adaptiven Filters adaptiv variiert wird, als Antwort auf das Verhältnis zwischen dem Kurzzeitmittelwert und dem Langzeitmittelwert der Information auf der Größenordnung des Ausgangssignals.

**2.** Verfahren nach Anspruch 1, wobei als die dem Ausgangssignal zugeordnete Information ein Quadratwert des Ausgangssignals des adaptiven Filters verwendet wird.

**3.** Verfahren nach Anspruch 1, wobei als die dem Ausgangssignal zugeordnete Information ein Absolutwert des Ausgangssignals des adaptiven Filters verwendet wird.

**4.** Verfahren nach Anspruch 1, wobei das Verhältnis zwischen dem Kurzzeit- und dem Langzeitmittelwert erhalten wird durch Invertieren und Multiplizieren mit der Invertierungsoperation, die durch lineare Approximation des Exponenten 2 erhalten wird.

**5.** Verfahren nach Anspruch 4, wobei das Inverse einer Variablen X in der Inversoperation erhalten wird durch eine lineare Approximation von $-2^{-2-r}X + 2^{-r-1} \cdot (2^{-1}+1)$ unter Verwendung der maximalen ganzen Zahl r, die $\log_2(X)$ nicht übersteigt.

**6.** Koeffizientensteuervorrichtung zum Steuern von Koeffizienten eines adaptiven Filters (3), der ein Pseudoausgangssignal an ein unbekanntes System abgibt, um das unbekannte System zu identifizieren oder periodische Signale vorhersagt beim Empfang eines Referenzsignals, mit:

einem ersten Subtrahierer (4) zum Subtrahieren des Pseudoausgangssignals von einem gemischten Signal des Ausgangssignals des unbekannten Systems und von Interferenzsignalen oder von periodischen Signalen und einem Breitbandsignal zum Identifizieren des unbekannten Systems, bzw. zum Erzeugen vorhergesagter Signale als Antwort auf die periodischen Signale,
einem Informationsextraktionsschaltkreis (9) zum Extrahieren von Information a direkt entsprechend der Größenordnung des Ausgangssignals des adaptiven Filters (3) durch Empfangen des Ausgangssignals von dem adaptiven Filter (3), und
einem arithmetischen Schaltkreis (10), der das Ausgangssignal a des Informationsextraktionsschaltkreises (9) empfängt zum Berechnen und Erzeugen eines Signals b, das abnimmt bei Zunahme des Ausgangssignals a oder zunimmt bei Abnahme des Ausgangssignals a,

wobei der adaptive Filter (3) die Koeffizienten des adaptiven Filters (3) korrigiert unter Verwendung der Ausgangssignale des ersten Subtrahierers (4), des arithmetischen Schaltkreises (10) und des Referenzsignals,
wobei die Größe der Korrektur der Koeffizienten des adaptiven Filters adaptiv variiert wird als Antwort auf das Verhältnis zwischen dem Kurzzeitmittelwert und dem Langzeitmittelwert der Information aufgrund der Größenordnung des Ausgangssignals.

**7.** Vorrichtung nach Anspruch 6, wobei der Informationsextraktionsschaltkreis (9) einen Quadrierschaltkreis (31) zum Erzeugen des Ausgangssignals des adaptiven Filters aufweist.

**8.** Vorrichtung nach Anspruch 6, wobei der Informationsextraktionsschaltkreis (9) einen Absolutwertschaltkreis (41) zum Erzeugen eines Absolutwerts des Ausgangssignals des adaptiven Filters aufweist.

**9.** Vorrichtung nach einem der Ansprüche 6 bis 8, wobei der arithmetische Schaltkreis (10) einen ersten Mittelungsschaltkreis (52) zur Mittelwertbildung eines Eingangssignals, einen zweiten Mittelungsschaltkreis (53) zur Mittelwertbildung des gleichen Eingangssignals mit unterschiedlicher Mittelungs-Zeitkonstanten gegenüber der Mittelungs-Zeitkonstanten des ersten Mittelungsschaltkreises und einen Dividierschaltkreis (54) zum Erzeugen eines Verhältnisses des ersten Mittelungsschaltkreises und des zweiten Mittelungsschaltkreis aufweist.

**10.** Vorrichtung nach Anspruch 9, wobei der Dividierschaltkreis (54) einen Invertierer (72) zum Ausgeben eines invertierten Signals des Ausgangs des zweiten Mittelungsschaltkreises (53) und einen ersten Multiplizierer (73) zum Multiplizieren des invertierten Signals mit dem Ausgangssignal des ersten Mittelungsschaltkreises (52) aufweist.

**11.** Vorrichtung nach Anspruch 10, wobei der arithmetische Schaltkreis (10) ein Inversschaltkreis ist mit:

einem Amplitudenberechnungsschaltkreis (801) zum Erzeugen der maximalen Ganzzahl r, die $\log_2(X)$ eines Eingangssignals X nicht übersteigt,
einem zweiten Multiplizierer (802) zum Multiplizieren des Ausgangssignals des Amplitudenberechnungsschaltkreises mit -1,
einem zweiten Addierer (803) zum Addieren von -1 zum Ausgang des zweiten Multiplizierers,

einem dritten Addierer (804) zum Erzeugen der Summe der Ausgänge des zweiten Multiplizierers (802) und des zweiten Addierers (803),

einem ersten Adressenerzeugungsschaltkreis (805) zum Erzeugen eines RAM-Adressignals zum Bilden eines Exponenten von 2 entsprechend dem Ausgangssignal des dritten Addierers (804),

einem zweiten Adressenerzeugungsschaltkreis (806) zum Erzeugen eines RAM-Adressignals und Bilden eines Exponenten von 2 entsprechend dem Ausgangssignal des zweiten Addierers (803),

einem RAM (807) zum Abgeben eines entsprechenden Exponentenausgangssignals von 2 bei Empfang der Ausgangssignale des ersten und des zweiten Adressenerzeugungsschaltkreises,

einem dritten Multiplizierer (808) zum Multiplizieren des Ausgangssignals entsprechend der Adresse, die von dem ersten Adressenerzeugungsschaltkreis in dem RAM erzeugt wurde, mit -1,

einem vierten Multiplizierer (809) zum Multiplizieren des Ausgangssignals des dritten Multiplizierers mit dem Eingangssignal zu dem Eingangsanschluß,

einem fünften Multiplizierer (810) zum Multiplizieren des Ausgangssignals entsprechend der Adresse, die von dem zweiten Adressenerzeugungsschaltkreis in dem RAM erzeugt wurde, mit 1.5, und

einem vierten Addierer (811) zum Addieren der Ausgangssignale des fünften und vierten Multiplizierers zum Ausgeben am Ausgangsanschluß.

## Revendications

1. Procédé de contrôle des coefficients d'un filtre adaptatif (3) pour identifier un système inconnu ou prévoir des signaux périodiques en recevant un signal mélangé formé du signal de sortie dudit système inconnu comprenant un signal d'interférence, ou des signaux périodiques et d'un signal à bande large, et en corrigeant les coefficients dudit filtre adaptatif (3) par le moyen d'un signal de différence qui est obtenu en soustrayant un signal de sortie du filtre adaptatif (3) dudit signal mélangé, ledit filtre adaptatif (3) recevant un signal de référence, ledit procédé comprenant les étapes consistant à :

   extraire l'information correspondant directement à l'amplitude du signal de sortie dudit filtre adaptatif (3) ;
   et de plus, faire varier de manière adaptative le taux de correction des coefficients dudit filtre adaptatif sur la base de l'information extraite, dans laquelle le taux de correction des coefficients dudit filtre varie de manière adaptative en réponse au rapport entre la moyenne à court terme et la moyenne à long terme de l'information sur l'amplitude du signal de sortie.

2. Procédé selon la revendication 1, dans lequel une valeur au carré du signal de sortie dudit filtre adaptatif est utilisée comme information concernant le signal de sortie.

3. Procédé selon la revendication 1, dans lequel une valeur absolue du signal de sortie dudit filtre adaptatif est utilisée comme information concernant le signal de sortie.

4. Procédé selon la revendication 1, dans lequel le rapport entre les moyennes à court terme et à long terme est réalisé par des opérations d'inversion et de multiplication, l'opération d'inversion étant faite par une approximation linéaire d'exposant de 2.

5. Procédé selon la revendication 4, dans lequel l'inverse d'une variable X dans l'opération d'inversion est obtenue par une approximation linéaire de $-2^{-2-r}X + 2^{-r-1}. (2^{-1}+1)$ en utilisant le nombre entier maximum r n'excédant pas $\log_2(X)$.

6. Un appareil de contrôle des coefficients pour contrôler les coefficients d'un filtre adaptatif (3) qui génère une pseudo sortie vers un système inconnu pour identifier ledit système inconnu, ou prévoir des signaux périodiques à la réception d'un signal de référence, comprenant un premier soustracteur (4) pour soustraire la pseudo sortie d'un signal mélangé formé du signal de sortie du système inconnu et de signaux d'interférence ou des signaux périodiques et d'un signal à bande large, pour, respectivement, identifier le système inconnu ou pour générer des signaux prévus en réponse aux dits signaux périodique,
   un circuit d'extraction d'information (9) pour extraire de l'information a correspondant directement à l'amplitude du signal de sortie dudit filtre adaptatif (3) en recevant le signal de sortie filtre adaptatif (3) ; et
   un circuit arithmétique (10) recevant la sortie a dudit circuit d'extraction d'information (9) pour calculer et fournir un signal b qui décroît quand le signal a augmente ou augmente quand le signal a décroît ;
   ledit filtre adaptatif (3) corrigeant les coefficients du filtre adaptatif (3) en utilisant la sortie du premier soustracteur (4), et ledit circuit arithmétique (10) et le signal de référence, dans lequel le taux de correction des coefficients dudit filtre varie de manière adaptative en réponse au rapport entre la moyenne à court terme et la moyenne à long terme de l'information sur l'amplitude du signal de sortie.

7. Appareil selon la revendication 6, dans lequel ledit circuit d'extraction d'information (9) comprend un circuit de mise au carré (31) pour développer la sortie dudit filtre adaptatif.

8. Appareil selon la revendication 6, dans lequel ledit circuit d'extraction d'information (9) comprend un circuit de valeur absolue (41) pour développer une valeur absolue de la sortie dudit filtre adaptatif.

9. Appareil selon l'une quelconque des revendications 6 à 8, dans lequel ledit circuit arithmétique 10 comprend un premier circuit de moyenne (52) pour faire la moyenne d'un signal d'entrée, un second circuit de moyenne (53) pour faire la moyenne du même signal d'entrée avec une constante de temps de moyenne différente de la constante de temps de moyenne dudit premier circuit de moyenne ; et un diviseur (54) pour développer un rapport desdits premier circuit de moyenne et second circuit de moyenne.

10. Appareil selon la revendication 9, dans lequel ledit diviseur (54) comprend un inverseur (72) pour sortir un signal inversé de la sortie dudit second circuit de moyenne (53) et un premier multiplicateur (73) pour multiplier le signal inversé avec la sortie dudit premier circuit de moyenne (52).

11. Appareil selon la revendication 10, dans lequel ledit circuit arithmétique (10) un circuit inverseur comprenant :

un circuit d'évaluation d'amplitude (801) pour fournir le nombre entier maximum r ne dépassant pas la valeur log2 (X) d'un signal d'entrée X ;
un second multiplicateur (802) pour multiplier la sortie dudit circuit d'évaluation d'amplitude par -1 ;
un second additionneur (803) pour ajouter -1 à la sortie dudit second multiplicateur ;
un troisième additionneur (804) pour fournir la somme des sorties desdits second multiplicateur (802) et second additionneur (803) ;
un premier circuit de génération d'adresse (805) pour fournir un signal d'adresse de RAM pour donner un exposant de 2 correspondant à la sortie dudit troisième additionneur (804) ;
un second circuit de génération d'adresse (806) pour fournir un signal d'adresse de RAM pour donner un exposant de 2 correspondant à la sortie dudit second additionneur (803) ;
une RAM (807) pour fournir un exposant de 2 en sortie à la réception des sorties desdits premier et second circuits de génération d'adresse ;
un troisième multiplicateur (808) pour multiplier la sortie correspondant à l'adresse générée à partir dudit premier circuit de génération d'adresse dans ladite RAM par -1 ;
un quatrième multiplicateur (809) pour multiplier la sortie dudit troisième multiplicateur par le signal d'entrée vers le terminal d'entrée ;
un cinquième multiplicateur (810) pour multiplier la sortie correspondant à l'adresse générée par ledit second circuit de génération d'adresse dans ladite RAM par 1,5 ; et
un quatrième additionneur (811) pour additionner les sorties desdits cinquième et quatrième multiplicateurs pour la sortie du terminal de sortie.

# F I G. 1

# FIG. 2

EP 0 715 407 B1

# F I G. 3

# F I G. 4

# FIG. 5

```
51          52
 ○────┬──→ [AVERAGE     ]──────→ ┌─────────┐  54
      │     [  CCT.      ]        │         │
      │                          │ DIVIDER │────→ ○
      │    53                    │         │      55
      └──→ [AVERAGE     ]──────→ │         │
            [  CCT.      ]        └─────────┘
```

# FIG. 6

```
        62            63                              66
 ○────[▷ β ]────→ ( + )──────────────────┬──────→ ○
61                   ↑                    │
                     │    64      65      │
                     └──[◁ I-β ]←──[ Z⁻¹ ]←──┘
```

# FIG. 7

```
70                    73
 ○──────────────────→ ⊗ ──────→ ○
                      ↑           74
        72            │
71     ┌──────────┐   │
 ○────→│ INVERTER │───┘
       └──────────┘
```

# FIG. 8

EP 0 715 407 B1

# FIG. 9

$1$

$s_k + v_k$

$d_k = s_k + v_k - \hat{V}_k$

$4$

$6$

$-$

$V_k$

$3$

$n_k$

ADAPTIVE
FILTER

$2$

$9$

INF. EXT.

$10$

$f [ \bullet ]$

# FIG. 10

F I G. 11

# F I G . 12

# FIG.13

# FIG. 14

$s_k + v_k$

$d_k = s_k + v_k - V_k$

ADAPTIVE FILTER

$V_k$

$2\alpha$

$n_k$

# FIG. 15

$s_k + v_k$

$d_k = s_k + v_k - V_k$

ADAPTIVE FILTER

$V_k$

$s_{k-L} + v_{k-L}$

$2\alpha$

$Z^{-L}$

26

# FIG. 16